# EUROPEAN PATENT SPECIFICATION

(11) **EP 2 636 057 B1**
(45) Date of publication and mention of the grant of the patent: **26.11.2014**
(21) Application number: 12731351.8
(22) Date of filing: 19.06.2012
(51) Int. Cl.: H01L 21/677

(54) **METHOD FOR CALIBRATING A ROBOT MOUNTED ON ACTIVE MAGNETIC BEARINGS**
VERFAHREN ZUM KALIBRIEREN EINES AUF AKTIVEN MAGNETLAGERN MONTIERTEN ROBOTERS
PROCÉDÉ POUR ÉTALONNER UN ROBOT MONTÉ SUR DES PALIERS MAGNÉTIQUES ACTIFS

(30) Priority: 20.06.2011 DE 102011077817; 10.01.2012 DE 102012200220
(43) Date of publication of application: 11.09.2013
(73) Proprietor: Semilev GmbH, 63868 Großwallstadt (DE)
(72) Inventor: OLDENDORF, Ulrich, 64372 Ober-Ramstadt (DE)
(74) Representative: Lippert, Stachow & Partner
(86) International application number: PCT/EP2012/061660
(87) International publication number: WO 2012/175473

(56) References cited:
- EP-A1- 1 137 052
- US-A1- 2002 068 992

## Description

The invention relates to a method for calibrating a robot mounted on active magnetic bearings and having a gripper, which is vertically positionable along the z axis, for picking up and handling silicon wafers and depositing them in a transporting box, in which a plurality of silicon wafers are storable at a fixed vertical spacing, wherein the gripper is displaceable in a first magnetic bearing along the x axis and in a second magnetic bearing along the y axis.

The designation silicon wafer stands for any kind of disc-like wafers, including those made of materials other than silicon, and for any desired application.

The currently used transporting boxes for in each case one stack of silicon wafers are open on one side and are provided, laterally on the inside and at the rear in the insertion direction, with guides for picking up and depositing a large number of silicon wafers one on top of another and for safely storing them. In such transporting boxes, which are also known as FOUPs (Front Open Unified Pod), the standardized spacing is currently 10 mm for silicon wafers stacked one on top of another, given a maximum size of the wafers of 450 mm. The gripper, which is also known as an end effector, has a fork-like shape and serves for engaging beneath the silicon wafers, initially without retaining the latter. In other words, the silicon wafers rest loosely on the gripper while they are being handled. Since the gripper itself has a thickness of 8 mm, only a small air gap of 1 mm remains above and below the gripper in order to position it in the spacing.

Accordingly, the robot has to position the gripper very precisely, in order to rule out damage to the surface of the silicon wafers while they are being handled. Given a diameter of the silicon wafers of currently 450 mm, this means a high demand in terms of the angle deviation to be kept within, which has to be better than ± 1/450, or 0.1°.

Previously, for such tasks, use was made of mechanically constructed handling robots, in which the requisite accuracy in the movement axes was set mechanically in combination with a mechanical orientation of the foundation. Since the moved parts are guided in mechanical bearing means in such devices, wear phenomena always have to be expected in the bearing points after a more or less long period of use.

This leads to a change in the accuracy in the respective movement axes or, as a result of settling of the foundation, to a loss of accuracy in the orientation of the grippers, such that, without complicated monitoring of the movements of the gripper, there is the threat of damage to the silicon wafers when they are removed from the transporting box or are deposited in the transporting box.

Although use can be made, for vertical alignment in the z direction, of a monitoring sensor which measures for example the distance of the respective mount from the underside of the silicon wafer and which factors the result into the position control of the silicon wafer in the z direction, compensation of angle errors (δ and ε) is not possible. In this case, δ stands for the angle deviation about the y axis and ε stands for the angle deviation about the x axis.

The invention is based on the object of creating a method for calibrating a robot mounted on active magnetic bearings, by way of which quick and precise orientation of the gripper is made possible before the removal of silicon wafers from a transporting box and before the renewed storage thereof in said transporting box.

The object underlying the invention is achieved in the case of a method of the type mentioned at the beginning by dividing the first and second magnetic bearings into in each case four mounting points,
- defining the setpoint centre coordinates for the X, Y, Z axis and also the setpoint values for the angular positions δ, ε and transformation of the setpoint values into setpoint values for the vertical setpoint positions of the in each case four mounting points,
- specifying actuating forces for the electromagnets of the in each case four mounting points,
- determining the current vertical position in each case for the in each case four mounting points,
- measuring the current vertical position z of the in each case four mounting points and conversion into actual centre coordinates, and
- comparing the actual centre coordinates with the setpoint centre coordinates, determining the deviation and repeating the preceding steps by specifying corrected setpoint values as setpoint centre coordinates until the deviation of the actual centre coordinates from the setpoint centre coordinates is zero.

In a first refinement of the method according to the invention, zero degrees is specified for the two angular positions δ, ε.

In a further refinement of the invention, the setpoint values for the angular positions δ, ε are determined by comparison of the actual angular positions δ, ε and are specified as setpoint centre coordinates for the angular positions δ, ε.

The conversion of the centre coordinates X, Y, Z and the angular positions δ, ε into vertical positions of the in each case four mounting points and vice versa is carried out preferably in each case in a transformation matrix.

Furthermore, it is provided that the setpoint/actual comparison takes place in at least one multiplexer.

For precise measurement of the actual angular positions δ, ε, the use of an inclination sensor is provided.

Alternatively, the orientation of the angular positions δ, ε of the robot can be carried out in relation to a reference position.

If the position of at least one silicon wafer is used as reference position, a calibration can be carried out for each working position of the gripper.

Alternatively or in addition, the actual angular positions δ, ε are measured in each case with the aid of distance sensors.

It is also possible to arrange in each case two distance sensors in each case at a defined distance from one another on the gripper.

Furthermore, the actual angular position δ can be measured with the aid of a distance sensor moved along the x axis by a given amount. For example, a distance sensor located on the gripper can be moved by the latter along the x axis.

### Summary of relevant prior art:

D1 (EP 1137052 A) discloses an automatic calibration system for wafer transfer robot, and its method of using, including possibilities of movement in vertical (Z), horizontal ( ), and radial (R) directions.

D2 (US 2002/0068992 A) discloses a system and method for moving wafer, set method being characterized by including a self teaching process for calibration step.

The invention will be explained in more detail in the following text by way of an exemplary embodiment. In the associated drawings:
- Fig. 1:: shows a robot, equipped with a gripper, for removing, handling and storing silicon wafers from or in a transporting box during removal;
- Fig. 2:: shows the robot according to Fig. 1 with a silicon wafer resting on the gripper after removal;
- Fig. 3:: shows a schematic illustration of a vertically adjustable active magnetic bearing;
- Fig. 4:: shows a three-dimensional illustration of the degrees of tilting freedom of a gripper of a robot for handling silicon wafers;
- Fig. 5:: illustrates the use of centre coordinates for central control in order to avoid overdeterminedness at four mounting points;
- Fig. 6:: shows the schematic illustration of the arrangement of actuators in the form of active magnetic bearings and associated distance sensors;
- Fig. 7:: shows the integration of transformation matrices into the control structure for the z axis;
- Fig. 8:: shows the schematic illustration of the arrangement of the actuators in the form of active magnetic bearings and associated distance sensors with an additional inclination sensor;
- Fig. 9:: shows the factoring of the inclination sensor into the control structure according to Fig. 7 for detecting the angle deviations δ and ε; and
- Fig. 10:: shows a schematic illustration of the determination of the angle deviation ε between the gripper and the silicon wafer.

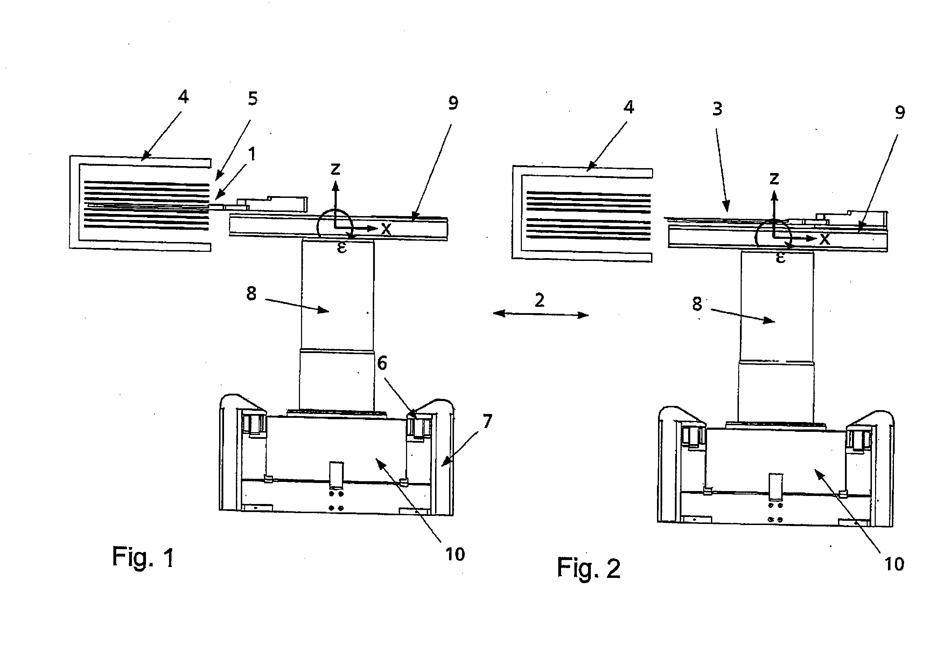

Figs 1 and 2 illustrate a robot 2, equipped with a gripper 1, for removing individual silicon wafers 3 from, or for storing them in, a transporting box 4 and also for handling them during the removal of a silicon wafer 3. In the transporting box 4, there is a wafer stack 5, in which the silicon wafers 3 are stacked one on top of another at a given spacing of currently 10 mm. The robot 2 rests on a carriage 10 that can be moved horizontally along a transporting section. The carriage 10 is mounted in a stationary frame 7 via vertically adjustable magnetic bearings 6. The magnetic bearing 6 allows a friction-free linear movement of the carriage 10 in the stationary frame 7. Furthermore, on the carriage 10 there is a likewise friction-free lifting/rotating support 8, at the top end of which the gripper 1 is arranged.

The lifting/rotating support 8 serves both for pivoting the gripper 1 in a plane about the z axis (vertical axis) and also for vertical positioning in a manner corresponding to the vertical spacing of the silicon wafers 3 located in the transporting box 4.

The gripper 1 located at the top end of the lifting/rotating support 8 is guided in a friction-free linear guide 9, which, by means of a linear drive (not illustrated), allows a horizontal movement of the gripper 1 along the x axis such that the gripper 1 can be positioned in the transporting box 4 under a silicon wafer 3 and be raised until the gripper has slightly lifted the respective silicon wafer 3 such that the latter can subsequently be removed from the transporting box by a reverse movement of the gripper 1. Individual silicon wafers 3 are stored in the transporting box 4 in the correspondingly reverse order.

Fig. 1 shows the gripper 1, which is positioned under a silicon wafer 3 in the wafer stack 5, in contact with a silicon wafer 3 and Fig. 2 shows the silicon wafer 3 located on the gripper 1 following its removal from the transporting box 4.

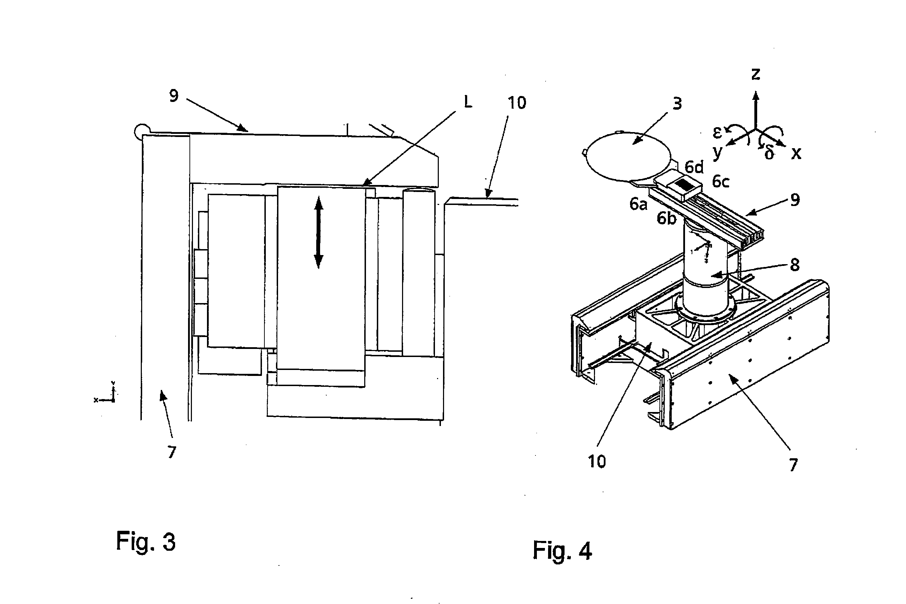

Fig. 3 illustrates details of a vertically adjustable active magnetic bearing 6 which can be moved on the stationary support frame 7 with the aid of a linear motor.

Fig. 4 shows a three-dimensional illustration of the degrees of tilting freedom δ and ε of the gripper 1 of the robot 2 for handling silicon wafers 3. The degrees of tilting freedom δ and ε can be adjusted by in each case four bearing points having in each case one adjustable magnetic bearing 6a, 6b, 6c, 6d of the linear guide 9 for the movement of the gripper 1 along the x axis, and by four bearing points having the magnetic bearings 6e, 6f, 6g, 6h for the movement of the carriage 10 in the support frame 7 along the y axis.

At these magnetic bearings 6, the respective air gap L, i.e. the position of the floating part, can be adjusted in the range of +- 1 mm in terms of control. The necessary air gap can be specified by software without a manual intervention being necessary. Given the individual specification of this floating position per bearing point e.g. for the x axis, i.e. the magnetic bearings 6a, 6b, 6c, 6d, the angular positions δ and ε can be adjusted in addition to the position in the z direction.

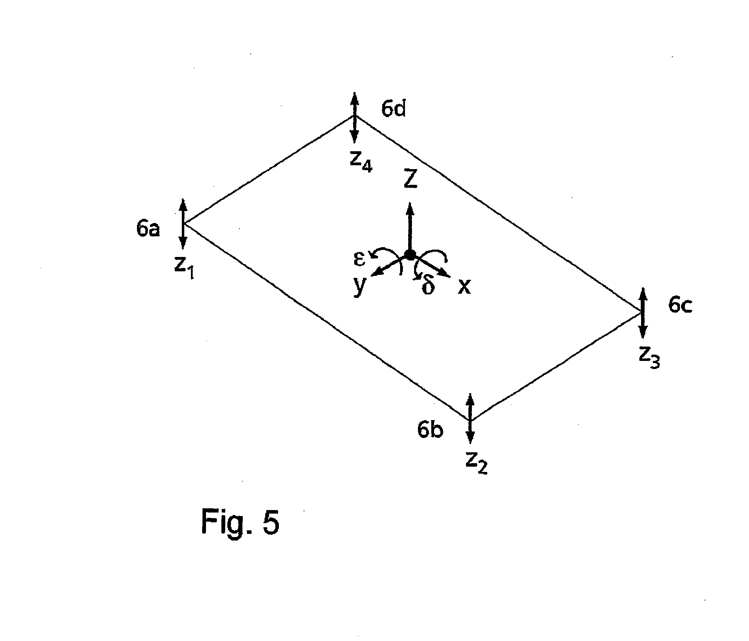

In order to avoid overdeterminedness in the case of four mounting points, centre coordinates are used for central position control, as is illustrated schematically in Fig. 5. As described above, the linear guide 9 for the gripper 1 contains four mounting points in magnetic bearings 6a, 6b, 6c, 6d, and the linear guide of the carriage 10 in the support frame 7 also contains four mounting points in magnetic bearings 6e, 6f, 6g, 6h.

In the following text, the transformation of the vertical positions of the in each case four mounting points of a magnetic bearing at centre coordinates X, Y, Z, δ and ε is described by way of example for the magnetic bearings 6a, 6b, 6c, 6d. To this end, first of all, at each mounting point of the magnetic bearings 6a, 6b, 6c, 6d, the current vertical position z1, z2, z3, z4 is determined by means of distance sensors 11a, 11b, 11c, 11d.

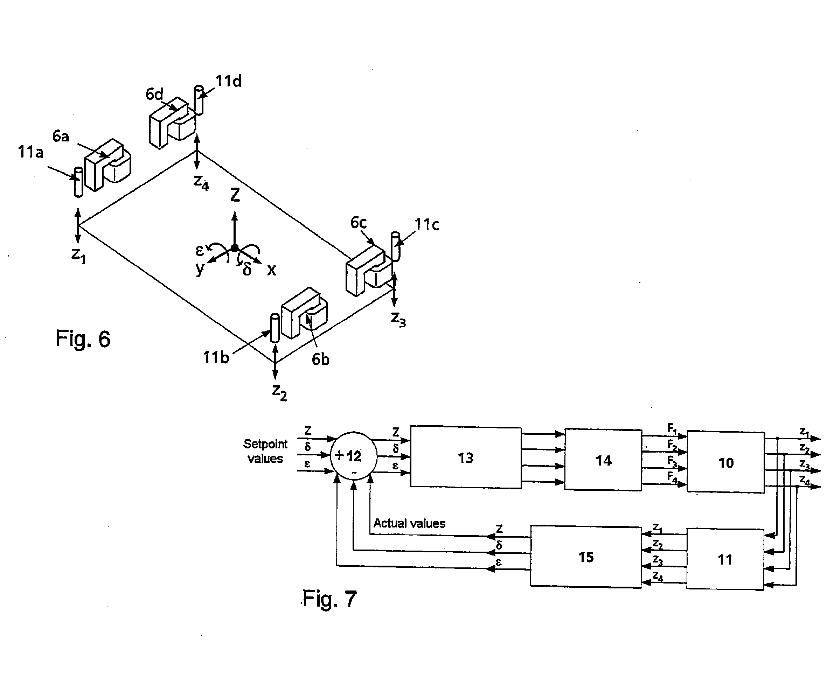

Fig. 6 shows the schematic illustration of the arrangement of actuators in the form of active magnetic bearings 6a, 6b, 6c, 6d and associated distance sensors 11a, 11b, 11c, 11d for the z axis, in order to determine the actual vertical positions z1, z2, z3, z4.

Fig. 7 illustrates a schematic signal flow diagram for an inner control circuit for position control according to the invention in the z axis and also the angular positions δ and ε about the x axis and y axis, respectively. For position control in the z axis and the angular positions δ and ε, the setpoint specifications for the centre coordinates of the z axis, i.e. the vertical position to be controlled of the gripper 1 and for the angular positions e.g. δ = 0° and ε = 0° are first of all input in a first multiplexer 12, which passes these values on in an unchanged manner to a transformation matrix 13. In the transformation matrix 13, the centre coordinates are converted into setpoint specifications for the vertical position to be selected of the mounting points 6a, 6b, 6c, 6d of the magnetic bearings and passed on in each case to the mounting points 6a, 6b, 6c, 6d of the magnetic bearings. At the mounting points 6a, 6b, 6c, 6d of the magnetic bearings, corresponding actuating forces F1, F2, F3, F4 are produced as a result and the carriage 10 is correspondingly moved.

The selected positions then still have to be checked and the setpoint values corrected, if appropriate, via feedback. To this end, the current vertical positions z1, z2, z3, z4 are determined by way of the distance sensors 11a, 11b, 11c, 11d and the actual values z1', z2', z3', z4' passed on to a further transformation matrix 16. Conversion into the actual values z', δ', ε' takes place in the transformation matrix 16.

These actual values are then compared with the setpoint values z, δ, ε in the first multiplexer 12. This comparison takes place until z1 = z1', z2 = z2', z3 = z3' and z4 = z4'.

It goes without saying that the centre coordinates x, f, z, δ and ε for the mounting points of the magnetic bearings 6e, 6f, 6g, 6h are determined in a corresponding manner.

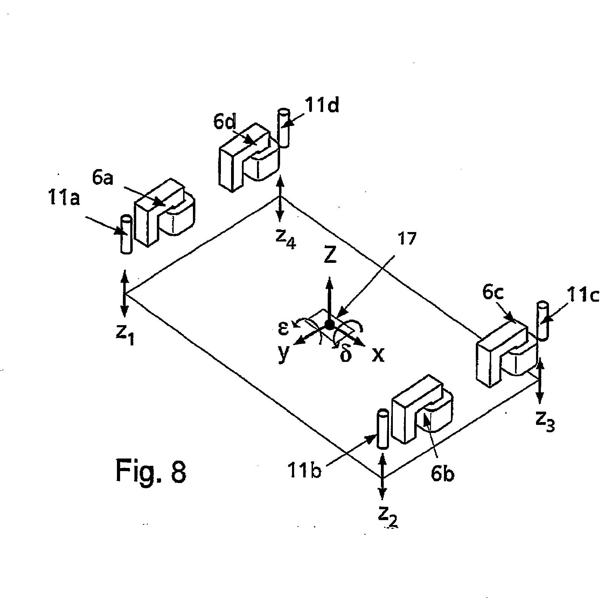

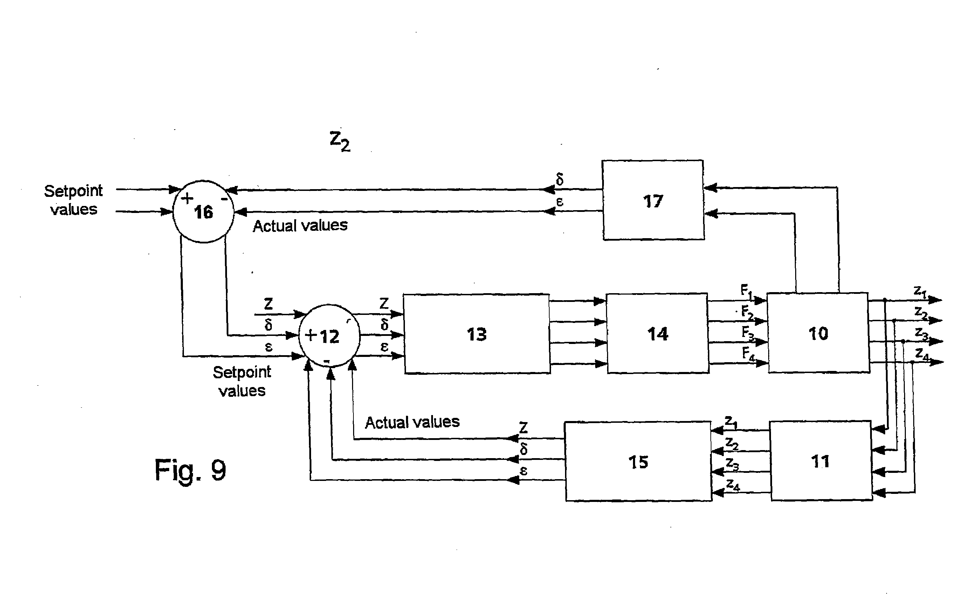

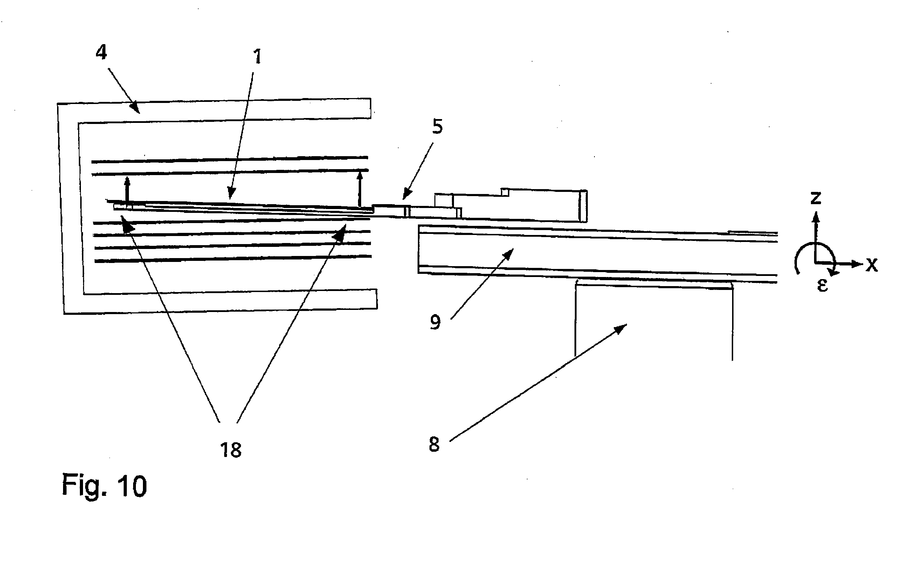

Fig. 8 shows the arrangement according to Fig. 6 supplemented by an inclination sensor 17, and Fig. 9 shows the inner control circuit according to Fig. 7 supplemented by an outer control circuit for incorporating an inclination sensor 17 for sensing the actual angular positions δ, ε. Thus, it is possible to specify the measured values for the angular positions δ, ε to the inner control circuit in the sense of precontrol. The inclination sensor of the outer control circuit can operate absolutely, i.e. in that a fixed setpoint value of 0 degrees is specified, or it can also be oriented in relation to a reference position. With such a relative measurement, it is possible, for example, to achieve a parallel orientation of the gripper 1 with respect to a silicon wafer 3 which is incorrectly positioned, as can be seen from Fig. 10.

To this end, distance sensors 18 are integrated into the gripper 1, it being possible to determine the relative angle or angle error between the gripper 1 and the silicon wafer 3 by way of said distance sensors 18. This angle is then used in an inverted manner as the setpoint value for the outer control circuit of the angular position according to Fig. 9.

The two distance sensors 18 are incorporated into the gripper 1 at a defined distance from one another and determine the distance between the gripper 1 and the silicon wafer 3 at a position on the x axis. Alternatively, it is also possible for measurements to be carried out at two positions on the x axis by only one distance sensor 18, in that the gripper 1 is moved by a specified amount along the x axis.

If the robot 1 is of multi-axis construction, the described calibration can be shared out between all of the air gaps of all of the magnetic bearings. In this case, the four mounting points for the x axis with the magnetic bearings 6a, 6b, 6c, 6d can also be used in a corresponding manner for the four mounting points of the magnetic bearings 6e, 6f, 6g, 6h for the y axis.

According to the method according to the invention, the first and second magnetic bearings are first of all divided into in each case four mounting points (6a, 6b, 6c, 6d; 6e, 6f, 6g, 6h) and the setpoint centre coordinates for the X, Y, Z axis and the setpoint values for the angular positions δ, ε are defined and then these setpoint values are transformed into setpoint values for the vertical setpoint positions of the in each case four mounting points (6a, 6b, 6c, 6d; 6e, 6f, 6g, 6h).

Subsequently, actuating forces F1-F4 for the electromagnets of the in each case four mounting points (6a, 6b, 6c, 6d; 6e, 6f, 6g, 6h) are specified and then the current vertical positions in each case for the in each case four mounting points (6a, 6b, 6c, 6d; 6e, 6f, 6g, 6h) are determined by measuring the current vertical position z of the in each case four mounting points (6a, 6b, 6c, 6d; 6e, 6f, 6g, 6h) and conversion into actual centre coordinates.

Then, the actual centre coordinates are compared with the setpoint centre coordinates and the deviation determined.

The above steps are repeated by specifying corrected setpoint values as setpoint centre coordinates, until the deviation of the actual centre coordinates from the setpoint centre coordinates is zero.

The described relative determination of the angular position allows calibration for each working position of the gripper 1, i.e. the orientation of the gripper 1 can be adjusted automatically to different values at different working positions.

### Method for calibrating a robot mounted on active magnetic bearings

### List of reference signs

- 1: Gripper
- 2: Robot
- 3: Silicon wafer
- 4: Transporting box
- 5: Wafer stack
- 6: Magnetic bearing
- 7: Frame/support frame for carriage
- 8: Lifting/rotating device
- 9: Linear guide
- 10: Carriage
- 11: Distance sensor
- 12: Multiplexer
- 13: Transformation matrix
- 14: Electromagnets of the active magnetic bearings
- 15: Transformation matrix
- 16: Second multiplexer
- 17: Inclination sensor
- 18: Distance sensor

- F: Actuating force
- L: Air gap
- δ: Degree of tilting freedom/angular position
- ε: Degree of tilting freedom/angular position

## Claims

1. Method for calibrating a robot mounted on active magnetic bearings and having a gripper, which is vertically positionable along the z axis, for picking up and handling silicon wafers and depositing them in a transporting box, in which a plurality of silicon wafers are storable at a fixed vertical spacing, wherein the gripper is displaceable in a first magnetic bearing along the x axis and in a second magnetic bearing along the y axis, **characterized by**
- dividing the first and second magnetic bearings into in each case four mounting points (6a, 6b, 6c, 6d; 6e, 6f, 6g, 6h);
- defining setpoint centre coordinates for the X, Y, Z axis and also setpoint values for angular positions δ, ε and transformation of the setpoint values into setpoint values for vertical setpoint positions of the in each case four mounting points (6a, 6b, 6c, 6d; 6e, 6f, 6g, 6h);
- specifying actuating forces F1-F4 for electromagnets of the in each case four mounting points (6a, 6b, 6c, 6d; 6e, 6f, 6g, 6h);
- determining a current vertical position in each case for the in each case four mounting points (6a, 6b, 6c, 6d; 6e, 6f, 6g, 6h);
- measuring a current vertical position z of the in each case four mounting points (6a, 6b, 6c, 6d; 6e, 6f, 6g, 6h) and conversion into actual centre coordinates;
- comparing the actual centre coordinates with the setpoint centre coordinates, determining a deviation of the actual centre coordinates from the setpoint centre coordinates and repeating the preceding steps by specifying corrected setpoint values as setpoint centre coordinates until the deviation is zero.

2. Method according to Claim 1, **characterized in that** zero degrees is specified for the two angular positions δ, ε.

3. Method according to Claims 1 and 2, **characterized in that** the setpoint values for the angular positions δ, ε are determined by comparison of the actual angular positions δ, ε and are specified as setpoint centre coordinates for the angular positions δ, ε.

4. Method according to Claim 1, **characterized in that** the conversion of the centre coordinates X, Y, Z and the angular positions δ, ε into vertical positions of the in each case four mounting points (6a, 6b, 6c, 6d; 6e, 6f, 6g, 6h) and vice versa is carried out in each case in a transformation matrix (13; 15).

5. Method according to one of Claims 1 to 3, **characterized in that** the setpoint/actual comparison takes place in at least one multiplexer.

6. Method according to one of Claims 1 to 5, **characterized in that** the actual angular positions δ, ε are measured by an inclination sensor.

7. Method according to one of Claims 1 to 5, **characterized in that** the orientation of the angular positions δ, ε of the robot 2 is carried out in relation to a reference position.

8. Method according to Claim 7, **characterized in that** the position of at least one silicon wafer (1) is used as reference position.

9. Method according to Claims 7 and 8, **characterized in that** the actual angular positions δ, ε are measured in each case with the aid of distance sensors (18).

10. Method according to Claim 9, **characterized in that** in each case two distance sensors (18) are arranged in each case at a defined distance from one another on the gripper (1).

11. Method according to Claim 9, **characterized in that** the actual angular position δ is measured with the aid of a distance sensor (18) moved along the x axis by a given amount.

## Patentansprüche

1. Verfahren zum Kalibrieren eines Roboters, der auf aktiven Magnetlagern montiert ist und einen Greifer aufweist, der vertikal entlang der z-Achse positioniert werden kann, um Siliziumwafer aufzunehmen und zu handhaben und sie in einer Transportbox abzulegen, in der mehrere Siliziumwafer mit einem festen vertikalen Abstand gelagert werden können, wobei der Greifer in einem ersten Magnetlager entlang der x-Achse und in einem zweiten Magnetlager entlang der y-Achse verschoben werden kann, **gekennzeichnet durch**
- Unterteilen des ersten und zweiten Magnetlagers in jedem Fall in vier Montagepunkte (6a, 6b, 6c, 6d; 6e, 6f, 6g, 6h);
- Definieren von Soll-Mittenkoordinaten für die X-, Y-, Z-Achse und auch Sollwerte für Winkelpositionen δ, ε und Transformation der Sollwerte in Sollwerte für vertikale Sollpositionen der in jedem Fall vier Montagepunkte (6a, 6b, 6c, 6d; 6e, 6f, 6g, 6h);
- Spezifizieren von Betätigungskräften F1-F4 für Elektromagnete der in jedem Fall vier Montagepunkte (6a, 6b, 6c, 6d; 6e, 6f, 6g, 6h);
- Bestimmen einer aktuellen vertikalen Position in jedem Fall für die in jedem Fall vier Montagepunkte(6a, 6b, 6c, 6d; 6e, 6f, 6g, 6h);
- Messen einer aktuellen vertikalen Position z der in jedem Fall vier Montagepunkte (6a, 6b, 6c, 6d; 6e, 6f, 6g, 6h) und Umwandlung in Ist-Mittenkoordinaten;
- Vergleichen der Ist-Mittenkoordinaten mit den Soll-Mittenkoordinaten, Bestimmen einer Abweichung der Ist-Mittenkoordinaten von den Soll-Mittenkoordinaten und Wiederholen der vorausgegangenen Schritte **durch** Spezifizieren korrigierter Sollwerte als Soll-Mittenkoordinaten, bis die Abweichung Null beträgt.

2. Verfahren nach Anspruch 1, **dadurch gekennzeichnet, dass** Null Grad für die beiden Winkelpositionen δ, ε spezifiziert wird.

3. Verfahren nach Anspruch 1 und 2, **dadurch gekennzeichnet, dass** die Sollwerte für die Winkelpositionen δ, ε durch Vergleich der Ist-Winkelpositionen δ, ε bestimmt werden und als Soll-Mittenkoordinaten für die Winkelpositionen δ, ε spezifiziert werden.

4. Verfahren nach Anspruch 1, **dadurch gekennzeichnet, dass** die Umwandlung der Mittenkoordinaten X, Y, Z und der Winkelpositionen δ, ε in vertikale Positionen der in jedem Fall vier Montagepunkte (6a, 6b, 6c, 6d; 6e, 6f, 6g, 6h) und umgekehrt in jedem Fall in einer Transformationsmatrix (13; 15) ausgeführt wird.

5. Verfahren nach einem der Ansprüche 1 bis 3, **dadurch gekennzeichnet, dass** der Soll-/IstVergleich in mindestens einem Multiplexer stattfindet.

6. Verfahren nach einem der Ansprüche 1 bis 5, **dadurch gekennzeichnet, dass** die Ist-Winkelpositionen δ, ε durch einen Neigungssensor gemessen werden.

7. Verfahren nach einem der Ansprüche 1 bis 5, **dadurch gekennzeichnet, dass** die Orientierung der Winkelpositionen δ, ε des Roboters 2 in Relation zu einer Referenzposition ausgeführt wird.

8. Verfahren nach Anspruch 7, **dadurch gekennzeichnet, dass** die Position mindestens eines Siliziumwafers (3) als Referenzposition verwendet wird.

9. Verfahren nach Anspruch 7 und 8, **dadurch gekennzeichnet, dass** die Ist-Winkelpositionen δ, ε in jedem Fall mit Hilfe von Abstandssensoren (18) gemessen werden.

10. Verfahren nach Anspruch 9, **dadurch gekennzeichnet, dass** in jedem Fall zwei Abstandssensoren (18) in jedem Fall in einem vorbestimmten Abstand voneinander am Greifer (1) angeordnet sind.

11. Verfahren nach Anspruch 9, **dadurch gekennzeichnet, dass** die Ist-Winkelposition δ mit Hilfe eines Abstandssensors (18) gemessen wird, der um ein gegebenes Ausmaß entlang der x-Achse bewegt wird.

## Revendications

1. Procédé d'étalonnage d'un robot monté sur des paliers magnétiques actifs et doté d'un préhenseur, qui peut être positionné verticalement le long de l'axe z, servant à saisir et à manipuler des tranches de silicium et à les déposer dans un caisson de transport, dans lequel une pluralité de tranches de silicium peut être rangée avec un espacement vertical fixé, le préhenseur pouvant être déplacé dans un premier palier magnétique le long de l'axe x et dans un deuxième palier magnétique le long de l'axe y, **caractérisé par** les étapes consistant à
- diviser les premier et deuxième paliers magnétiques en quatre points (6a, 6b, 6c, 6d; 6e, 6f, 6g, 6h) de montage chacun;
- définir des consignes de coordonnées du centre pour les axes X, Y, Z et également des valeurs de consignes pour des positions angulaires δ, ε et une transformation des valeurs de consignes en valeurs de consignes pour des consignes de position verticale des quatre points respectifs (6a, 6b, 6c, 6d; 6e, 6f, 6g, 6h) de montage;
- spécifier des efforts d'actionnement F1-F4 pour des électro-aimants des quatre points respectifs (6a, 6b, 6c, 6d; 6e, 6f, 6g, 6h) de montage;
- déterminer une position verticale actuelle dans chaque cas pour les quatre points respectifs (6a, 6b, 6c, 6d; 6e, 6f, 6g, 6h) de montage;
- mesurer une position verticale actuelle z des quatre points respectifs (6a, 6b, 6c, 6d; 6e, 6f, 6g, 6h) de montage et une conversion en coordonnées réelles du centre;
- comparer les coordonnées réelles du centre aux consignes de coordonnées du centre, déterminer un écart des coordonnées réelles du centre par rapport aux consignes de coordonnées du centre et répéter les étapes précédentes en spécifiant des valeurs de consignes corrigées en tant que consignes de coordonnées du centre jusqu'à ce que l'écart soit nul.

2. Procédé selon la revendication 1, **caractérisé en ce que** zéro degré est spécifié pour les deux positions angulaires δ, ε.

3. Procédé selon les revendications 1 et 2, **caractérisé en ce que** les valeurs de consignes pour les positions angulaires δ, ε sont déterminées par comparaison des positions angulaires réelles δ, ε et sont spécifiées en tant que consignes de coordonnées du centre pour les positions angulaires δ, ε.

4. Procédé selon la revendication 1, **caractérisé en ce que** la conversion des coordonnées X, Y, Z du centre et les positions angulaires δ, ε en positions verticales des quatre points respectifs (6a, 6b, 6c, 6d; 6e, 6f, 6g, 6h) de montage et vice versa est réalisée dans chaque cas dans une matrice (13; 15) de transformation.

5. Procédé selon l'une des revendications 1 à 3, **caractérisé en ce que** la comparaison consigne/réel a lieu dans au moins un multiplexeur.

6. Procédé selon l'une des revendications 1 à 5, **caractérisé en ce que** les positions angulaires réelles δ, ε sont mesurées par un capteur d'inclinaison.

7. Procédé selon l'une des revendications 1 à 5, **caractérisé en ce que** l'orientation des positions angulaires δ, ε du robot 2 est réalisée par rapport à une position de référence.

8. Procédé selon la revendication 7, **caractérisé en ce que** la position d'au moins une tranche (3) de silicium est utilisée comme position de référence.

9. Procédé selon les revendications 7 et 8, **caractérisé en ce que** les positions angulaires réelles δ, ε sont mesurées dans chaque cas à l'aide de capteurs (18) de distance.

10. Procédé selon la revendication 9, **caractérisé en ce que**, dans chaque cas, deux capteurs (18) de distance sont disposés dans chaque cas à une distance définie l'un de l'autre sur le préhenseur (1).

11. Procédé selon la revendication 9, **caractérisé en ce que** la position angulaire réelle δ est mesurée à l'aide d'un capteur (18) de distance déplacé d'une quantité donnée le long de l'axe x.
